# EUROPEAN PATENT APPLICATION

(11) **EP 4 819 029 A1**
(43) Date of publication of application: **07.10.2026**
(21) Application number: 25168608.5
(22) Date of filing: 04.04.2025
(51) Int. Cl.: G06Q 50/26, G06N 20/00

(54) **SYNTHETIC POPULATION DATA GENERATION AND USE THEREOF**

(71) Applicant: Fujitsu Limited, Kawasaki-shi, Kanagawa 211-8588 (JP)
(72) Inventor: OLMEZ, Sedar, SL1 2BE Slough (GB)
(74) Representative: Haseltine Lake Kempner LLP

(57) **Abstract**

A method for synthetic data generation, the method comprising: accepting input of a target geographic region; acquiring aggregated demographic data for the target geographic region; generating a synthetic population based on the aggregated demographic data using iterative proportional fitting; acquiring infrastructure information for the target geographic region; assigning the synthetic population to a plurality of households using the infrastructure information, thereby forming synthetic population data; outputting the synthetic population data for further use.

## Description

### Technical Field

The present disclosure relates to synthetic population data generation. More particularly, the present disclosure relates to methods for synthetic data generation, retrieval and use thereof, and related data processing apparatuses, computer programs and computer-readable storage media.

### Background

Increasing sophistication of personalised technologies across various sectors, including healthcare, consumer good manufacturing, and urban planning, has highlighted a notable deficiency in current data collection and analysis methodologies: the over-reliance on aggregated population statistics. While aggregated population data provides valuable insights at a macro-level, such data obscures the inherent heterogeneity within populations, leading to inaccurate conclusions and ineffective solutions when applied to individual needs.

Acquiring micro-level (individual level) statistics regarding people and households is a time-consuming process however, and often requires sourcing data from various organisations, which often unavoidably varies due to the variety of data collection methodologies. Data acquisition processes may be costly and are often legally constrained by regulations such as GDPR, making it difficult to access micro-level population information. Use of census data, for example, from multiple geographic regions may involve accessing separate websites and overcoming jurisdictional constraints, making it difficult to gather and use data concerning multiple populations across the world. To the best of the inventor's knowledge, there is no single, unified dataset or data format for population data curation across different geographic regions. This therefore necessitates extensive data wrangling and re-development for each new intended use case for the data.

For instance, in the pharmaceutical industry, the "one-size-fits-all" approach to drug development and dosage, based on average population responses, often results in suboptimal efficacy and increased adverse reactions for specific patient subgroups. Similarly, in urban planning, relying solely on aggregated mobility data may lead to infrastructure designs that fail to address the specific transportation needs of vulnerable populations, such as the elderly or disabled.

Further, the rise of personalised medicine, driven by advancements in genomics and wearable sensor technology, demands the availability of granular, individual-level population data to tailor treatments and interventions to specific patient profiles. This demand extends beyond healthcare, influencing the development of personalized consumer products, targeted marketing strategies, and customised educational programs.

There is therefore a pressing need for improved methodologies for providing individual-level population data while addressing critical concerns related to privacy and data security. The ability to accurately capture and utilise individual-level data is expected to unlock significant potential for developing more effective, targeted, and personalised solutions across a wide range of applications, ultimately leading to improved outcomes for individuals and society as a whole.

### Summary

According to an aspect of the disclosure, there is provided a computer-implemented method for synthetic data generation, the method comprising: accepting input of a target geographic region; acquiring aggregated demographic data for the target geographic region; generating a synthetic population based on the aggregated demographic data using iterative proportional fitting; acquiring infrastructure information for the target geographic region; assigning the synthetic population to a plurality of households using the infrastructure information, thereby forming synthetic population data; and outputting the synthetic population data.

Embodiments of another aspect of the disclosure include a data processing apparatus, which comprises a memory, a processing unit and means for accepting input. The memory stores computer-executable instructions to carry out a computer-implemented method for synthetic data generation. The processing unit and the means for accepting input are configured to execute the instructions.

Embodiments of another aspect of the disclosure include a computer program comprising instructions, which, when executed a data processing apparatus, causes the data processing apparatus to execute a computer-implemented method for synthetic data generation.

Embodiments of another aspect of the disclosure include a non-transitory computer-readable storage medium comprising instructions, which, when executed by a data processing apparatus, cause the data processing apparatus to execute a computer-implemented method for synthetic data generation.

Embodiments may be implemented in digital electronic circuitry, or in computer hardware, firmware, software, or in combinations thereof. Embodiments may be implemented as a computer program or a computer program product, i.e., a computer program tangibly embodied in a non-transitory information carrier, e.g., in a machine-readable storage device or in a propagated signal, for execution by, or to control the operation of, one or more hardware modules.

A computer program may be in the form of a stand-alone program, a computer program portion, or more than one computer program, and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of embodiments may be performed by one or more programmable processors executing a computer program to perform functions of the embodiments by operating on input data and generating output data. An apparatus of an embodiment may be implemented as programmed hardware or as special purpose logic circuitry, including, for example, a field programmable fata array, FPGA, or an application-specific integrated circuit, ASIC.

Processors suitable for the execution of a computer program include, by way of example, both general and special purpose microprocessors, and any one or more processors of any kind of digital computer. Generally, a processor will receive instructions and data from a read-only memory or a random access memory or both.

The invention is described in terms of particular embodiments. Other embodiments are within the scope of the following claims. For example, the steps of embodiments may be performed in a different order and still achieve desirable results.

Aspects of embodiments have been described using such terms as "computing means", "means for accepting input", and "processing unit". The skilled person will appreciate that such functional terms and their equivalents may refer to parts of the system that are spatially separate but combine to serve the function defined. Equally, the same physical parts of the system may provide two or more of the functions defined. For example, separately defined means may be implemented using the same memory and/or processor as appropriate.

### Brief Description of the Drawings

Reference is made, by way of example only, to the accompanying drawings in which:
Figure 1 is a flowchart of a general method for synthetic data generation according to embodiments;
Figure 2 is a schematic overview of modules and datastores as used in a synthetic data generation method;
Figure 3 is a schematic overview of modules and datastores as used in an alternative synthetic data generation method;
Figure 4 is a flowchart of a method of iterative proportional fitting;
Figure 5 is an example graphical user interface, GUI, panel for synthetic data generation;
Figure 6 is the example GUI panel for synthetic data generation in use;
Figure 7 is an example GUI panel for synthetic data visualisation;
Figure 8 is another example GUI panel for synthetic data visualisation; and
Figure 9 is a schematic overview of computing means suitable for implementing embodiments.

### Detailed Description

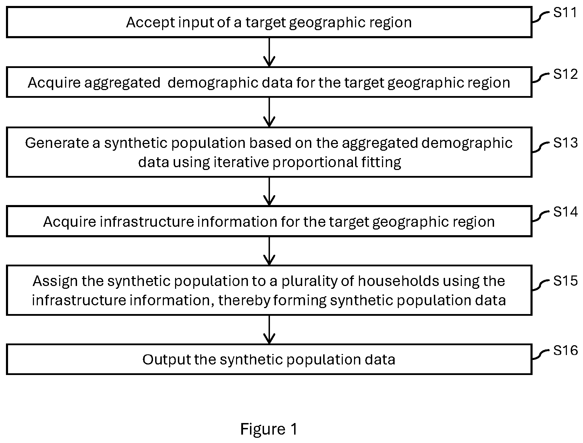

Figure 1 is an overview of a general method for synthetic data generation according to aspects of the present disclosure. The general method for synthetic data generation is implemented using computing means.

At S11, the computing means accepts input of a target geographic region. This target geographic region may be indicated through input of the name of a city, town, prefecture, etc., of interest. The geographic region may be indicated using a geocode entry (e.g., a location code or key, which may be provided in a lookup table), providing a unique identifier of the geographic region. For example, the Nomenclature of Territorial Units for Statistics, NUTS, standard may be used to enable input of entire EU countries, or any hierarchical subdivision of the country.

At S12, the computing means acquires real, aggregated demographic data for the input target geographic region. For instance, the computing means may access external computing resources and download the corresponding aggregated demographic data for the target geographic region. In some arrangements, the computing means may access multiple sources of aggregated demographic data. If necessary, suitable data-cleansing or data aggregation techniques may be applied to the aggregated demographic data. Demographic data in this context refers to aggregated statistical data for human populations, reflective of external physical reality, including - for example - population size, composition (e.g., ethnic group, age), fertility rates (births), mortality rates (deaths), and migration rates. Suitable sources for acquisition of aggregated demographic data include Eurostat.

At S13, the computing means generates an initial synthetic population based on the aggregated demographic data. The computing means uses the statistical technique iterative proportional fitting, IPF, to weight the aggregated data (i.e., observations) and then to apply weighted sampling (using these weights) such that the resulting sampled data reflects the desired proportions. This synthetic population corresponds to individual-level data for the geographic region. Use of IPF ensures accurate representation of demographic statistics.

At S14, the computing means acquires real infrastructure information for the target geographic region. This infrastructure information may include any or all of building boundaries, building centroids, building types (e.g., residential, commercial) transportation (e.g., road, railway) edges, and geographic region boundaries for the target geographic region in question. Suitable sources for acquisition of infrastructure data include OpenStreetMap. Infrastructure information in this context is reflective of external physical reality.

At S15, the computing means assigns each individual represented within the synthetic population to a household from amongst a plurality of households using the infrastructure information. For instance, distinct individuals may be allocated to each residential property as indicated by the infrastructure information. In this way, the computing means prepares individual-level synthetic population data. For example, where the geographic region in question is the city London, and thus the infrastructure information includes building boundaries and centroids within London, the individuals within the synthetic population may be assigned to these London-located buildings. The synthetic population data, for example, may comprise any or all of age, gender, health status, income status, ethnicity, and household information for each individual represented within the synthetic population data.

For example, with knowledge of the (aggregated) demographic spread of people living in a particular city/town, it is then possible to proportionally distribute the individuals into households and the households to the building locations randomly. For instance, each individual may be assigned a household ID and where two people are assigned the same household ID then their household latitude and longitude would be the same in the resultant synthetic population data.

At S16, the computing means outputs the individual-level synthetic population data. The output may be in any data format suitable for further intended use of the synthetic population; particularly suitable data formats include comma-separated value, CSV, files and extensible markup language, XML, files. The synthetic population includes a household (which are made up of member individuals with various demographic attributes (primarily age and gender)), which are assigned to real-world locations (in the form of GPS positions) throughout the target region.

The general method for synthetic data generation may utilise readily available aggregated statistics from multiple sources (including, for example, Eurostat, Synthetic Population Catalyst, health survey data, spatial interaction models, census data, Open Street Map) to produce a synthetic population dataset, reflective of the target geographic region's population. In use of a mathematical model that is able to take aggregated statistics and produce individual-level data, the data generation technique herein ensures realistic estimates of a population for any city or country.

The data generation technique herein may create individual-level data, including characteristics such as demographic data, ethnicity, age, health, income, household status, household location, for any geographic region for which aggregated-level data exists. The user is required to perform only minimal input, significantly reducing the time and the effort required using conventional means. By using aggregated statistics, the data generation technique herein bypasses the need for costly and legally constrained data retrieval processes, thus providing time and resource savings. From the end user's perspective, a software module embodying techniques herein requires only the geographic name as input and uses a unique set of algorithmic steps to acquire aggregated population statistics, fitting the proportions to the individual-level synthetic population. This, in turn, creates a comprehensive synthetic dataset based on real-world statistics and real-world demographics.

In some embodiments, the computer-implemented method for synthetic data generation may further involve the computing means assigning ethnicity prediction data to the synthetic population using ethnicity demographic data for the target geographic region. Optionally, the ethnicity demographic data may be acquired using a large language model, LLM. For example, a preprepared database comprising ethnicity data for a plurality of geographic regions may be consulted. The preprepared database may be initially prepared using a suitable LLM prompt and suitable processing of the LLM output. Alternatively, a live API connection with an LLM may be used to assign ethnicity data for the synthetic population. Use of LLM data provides additional statistics on demand for a more realistic population representation.

While LLMs have shown promise in data generation, their application in synthetic population generation is still limited. Existing methods often lack the ability to leverage LLMs effectively for tasks like ethnicity prediction and data curation. The present disclosure allows for effective integration of LLMs for tasks like ethnicity prediction, enabling more accurate and nuanced representation of population demographics.

One example LLM suitable for implementation is OpenAI's generative pretrained transformer-based models, including GPT-4 and o3. Other suitable LLMs include Meta AI's LlaMA models, including Llama 3.3, and Google AI's Gemini models, including Gemini 2.0 Flash. Of course, demographic data aside from ethnicity may be obtained using an LLM, including population income.

In some embodiments, the computer-implemented method for synthetic data generation may further involve the computing means accepting input of a target timepoint and acquiring the aggregated demographic data for the target geographic region and the target timepoint. Additionally or alternatively, the computing means may acquire the infrastructure information for the target geographic region and the target timepoint. In this way, the resultant synthetic population data may be representative of the population and spread within the target geographic region for a historical timepoint or a future timepoint (e.g., a specific year or month), thereby enabling use of the synthetic population data for historical analysis or for future predictive analysis. In the event that data for the specified timepoint is not available, data for the closest available timepoint may be used.

In some embodiments, the computer-implemented method for synthetic data generation may be accessible using a graphical user interface, GUI, thereby providing the end user with a continued-guided human-machine interface for the production (and possibly the subsequent use) of synthetic population data. The computing means may provide the GUI and accept input of the target geographic region (and any other necessary parameter) using the GUI. The computing means may be configured to output a representation of the synthetic population data using the GUI, which may be in the form of tabulated data or may be in the form of a map-based visualisation of the population. In this way, a platform that incorporates synthetic population data generation and retrieval in the backend enables end users to interactively browse the data.

The synthetic population data provided using the techniques herein is necessarily anonymised and therefore provides individual-level population data while addressing critical concerns related to privacy and data security. The ability to accurately capture and utilise individual-level data is expected to unlock significant potential for developing more effective, targeted, and personalised solutions across a wide range of applications. For example. the synthetic population data may be used within traffic simulations for the geographic region, where a microscopic, agent-based traffic simulation may further use real, acquired traffic data for the geographic region. The traffic simulation may be configured to generate a simulation prediction of traffic in the geographic region, with regard to the synthetic population of the graphic region (e.g., including population density in sub-regions).

The synthetic population data be additionally or alternatively be used in a resource allocation simulation for the geographic region, where the resource allocation simulation uses real resource data for the geographic region. For instance, the synthetic population data may thereby allow for healthcare resource allocation strategy and vaccination rollout strategy, with regard to the synthetic population of the graphic region. The techniques herein therefore allow for the development of targeted health interventions for the elderly, for low-income households, etc.

The synthetic population data be additionally or alternatively be used in an epidemiology simulation for the geographic region, where the epidemiology simulation further uses real epidemiologic data for the geographic region. For instance, the synthetic population data may thereby allow for accurate forecasting and prediction of disease outbreak within the geographic region and allow for healthcare or emergency response resource allocation.

These - and other - use cases enable simulations with improved accuracy. The synthetic population data reflects current demographics more accurately than traditional census data. The data enables timely decision-making with up-to-date data and provides detailed insights, with granular age, gender, and household information.

In some embodiments, the computer-implemented method for synthetic data generation may be utilised in combination with alternative data generation or data retrieval techniques. For instance, where population data already exists in a suitable format and is available for some (but not all) geographic regions, the end user may avoid initiating unnecessary computational processing using the above-described techniques and, instead, retrieve the suitable data directly. In this way, an aspect of the present disclosure provides a method for obtaining population data for a geographic region as implemented using computing means. The computing means accepts input of a target geographic region. When the target geographic region corresponds to a region included within a first predetermined plurality of geographic regions, the computing means generates synthetic population data for the target geographic region using the method for synthetic population data generation as described above. When the target geographic region, instead, corresponds to a region included within a second predetermined plurality of geographic regions, retrieving population data for the target geographic region. The retrieved population data may, of course, be pre-processed and cleansed as required.

Techniques according to the present disclosure addresses the challenges of data inconsistency, limited geographic coverage, and lack of micro-level detail in existing synthetic population generation methods. These techniques achieve this through a combination of standardised data integration techniques, handling of a broad, unrestricted geographic scope, and, for example, the effective utilisation of LLMs.

Techniques tackle the problem of inconsistent data formats and varying levels of granularity by integrating data from multiple sources, including, for example, Eurostat and the Synthetic Population Catalyst, into a unified, synthetic dataset. This eliminates the need for extensive data wrangling and ensures consistency across different regions, making it easier for the end user to generate accurate and comparable synthetic population data.

Techniques expand the geographic scope of synthetic population generation by providing a unified solution for various geographic regions across the world, including for example across the UK and across the EU. This eliminates the need for separate data development for each new location, making the techniques herein more efficient and scalable in comparison to existing techniques.

Techniques herein generate micro-level data, including, for example, individual characteristics and household composition. This provides a more detailed and realistic representation of the population than with existing techniques, making the techniques herein suitable for a wide range of applications that require granular information.

In some arrangements, the techniques herein leverage LLMs for tasks such as ethnicity prediction, thereby enhancing the accuracy and nuance of the generated synthetic populations. This addresses the limitations of existing methods that often struggle to accurately represent diverse demographics.

In combining all of these advantageous features, the techniques herein offer a standardised, comprehensive, and efficient approach to generating synthetic population data. This not only improves the quality and accessibility of synthetic data for various applications but also reduces the time and cost associated with data acquisition and processing.

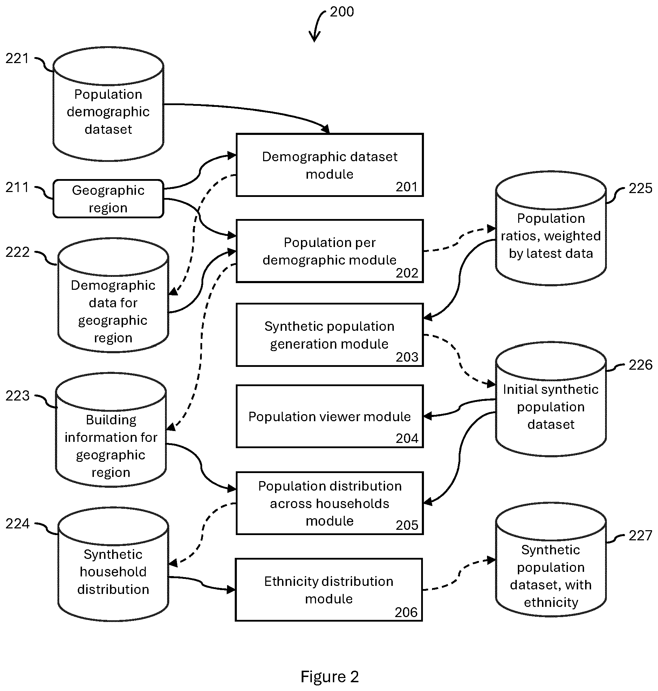

Figure 2 is a schematic overview of example modules and datastores as used in a synthetic data generation method. The modules here may be collectively referred to a synthetic data generation module 200.

The synthetic data generation module 200 is designed to create a realistic and detailed population dataset for a specified geographic region, e.g., city. This resultant synthetic population data includes various demographic attributes, geographic coordinates, and other relevant information. The module 200 processing comprises the following steps. In the following examples, the open source Eurostat database is used as source for aggregated demographic data, the open source OpenStreetMap database is used as source for infrastructure information, and the Python package qwiki is used to obtain up-to-date population estimates for the specified geographic region.

Initially, the user provides the name of the geographic region 211 through a graphical interface. Through use of known fuzzy matching techniques, the best match for the geographic region is determined, finding the closest matching row in a Eurostat data file based on the provided geographic region name. The user may additionally select a specific demographic indicator for later visualisation and/or debugging purposes (for example, the user may wish to visualise the proportion of population aged 80 years and more, through selection of the Eurostat indicator "PC_Y80_MAX" - this enables the user to quickly visualise if trends for a specific demographic indicator are accurate). Optionally, the user may further input a target timepoint, such that the synthetic population data representative for that timepoint.

Demographic dataset module 201 then consults the full population demographic dataset 221 (the Eurostat database in this example) and downloads and processes the aggregated demographic data 222 for the specified geographic region 211. This process includes downloading the data and, if required, cleaning the data, displaying unique values, filtering by country, and visualising the data.

Population per demographic module 202 consults the full infrastructure dataset (not shown; OpenSteetMap in this example) and downloads the corresponding infrastructure data for the geographic region 211. This module 202 is used to collect boundary data, building polygons, and transportation data. The infrastructure data is processed to obtain centroids for building polygons, and - if necessary - may be combined with NUTS boundary data for the larger region (e.g., country) in which the geographic region 211 is located. Module 202 outputs building information for the geographic region 223. Population data for the geographic region 211 may be retrieved from alternative sources, including Wikidata. The demographic data for the geographic region 222 is prepared based on the Eurostat data, with population distribution calculated across different years and all available demographic indicators.

Synthetic population generation module 203 generates an initial synthetic population for the specified geographic region 211 (and target timepoint, if applicable) using an iterative proportional fitting technique, which will be described later. This synthetic population data is saved to a temporary file, initial synthetic population dataset 226.

Population viewer module 204 may be executed at this point so as to visualise the initial synthetic population data 226 in tabulated form.

Population distribution across households module 205 then assigns households to individual buildings, based on the initial synthetic population data 226 and building information for the geographic region 223. The initial synthetic population dataset 226 is thereby merged with building data to create a comprehensive dataset, which includes information detailing the residential address of each individual person within the synthetic dataset and information detailing the household makeup (e.g., the number of people sharing one residence and their relationship status with one another). The synthetic household distribution data 224 is further processed and saved.

In the present example ethnicity distribution module 206 is used to integrate ethnicity data into the synthetic population dataset through use of using a Large Language Model, which enables access to up to date aggregated ethnicity statistics for the given geographic region 211 (insofar as the underlying LLM is trained on up to date data). The ethnic distribution is calculated and assigned to individuals in the synthetic population dataset, ensuring that the total population is accurately represented.

The synthetic data generation module 200 ultimately outputs a merged synthetic population dataset, containing demographic and geographic information. The synthetic population dataset, with ethnicity, 227 is saved as a CSV file.

In the present example, the synthetic data generation module 200 is implemented using Python. A single Python script may be used as a central control for the complex data processing pipeline, and may bring together a series of scripts (each performing the functionality of modules 201 to 206) to generate the synthetic population dataset for a target geographic region, incorporating real-life demographic and geographic information. The central control script may initially import the necessary Python libraries for data manipulation, fuzzy matching, and API interactions. These include pandas, numpy, sys, csv, fuzzywuzzy, and custom modules for each stage of the pipeline.

An example SyntheticPopulationGenerator class and schema is provided to generate synthetic population data for a specific geographic region (and timepoint) using demographic statistics. In the present example, the geographic region is a city and the timepoint is a specific year.

### Class: SyntheticPopulationGenerator

a. Attributes:
   i. year: The year for which the synthetic population is generated (initialised as None).
   ii. city: The city for which the synthetic population is generated.
   iii. es_key: A key used to access specific demographic data .
   iv. age_distribution_indicators: A list of indicators representing different age groups.
   v. age_group_labels: A list of labels for different age groups.
   vi. age_group_ranges: A dictionary defining the age range for each age group label.
b. Initialisation (__init__ method):
   i. Args:
      1. city (str): The city for which the synthetic population is generated.
      2. es_key (str): The key used to access specific data.
   ii. Attributes Initialised:
      1. year, city, es_key
      2. age_distribution_indicators, age_group_labels, age_group_ranges
c. Methods:
   i. load_and_prepare_data:
      1. Loads and prepares demographic data from a CSV file.
      2. Performs data cleaning and interpolation to handle missing values.
      3. Converts data to a long format for easier manipulation.
      4. Creates a pivot table with geographical and year levels for easy data access.
   ii. generate_synthetic_population:
      1. Generates a synthetic population for a given year.
      2. Args:
         a. year (int): The year for which the synthetic population is generated.
      3. Returns:
         a. A pandas.DataFrame containing the synthetic population data.
      4. Process:
         a. Filters demographic data for relevant age distribution indicators.
         b. Finds and uses the closest available year if data for the requested year is missing.
         c. Calculates total population and age distribution.
         d. Initialises the population based on age distribution.
         e. Adjusts the population using Iterative Proportional Fitting.
         f. Assigns random ages within age group ranges.
         g. Generates gender distribution based on demographic data.
         h. Assigns household IDs and saves the synthetic population data to a CSV file.
   iii. initialise_population:
      1. Initialises the population array with a given age distribution.
      2. Args:
         a. total_population (int): Total number of individuals in the population.
         b. age_distribution (pd.Series): Age distribution of the population.
      3. Returns:
         a. A numpy.array representing the initial population with age distribution.
   iv. apply_ipf:
      1. Applies Iterative Proportional Fitting (IPF) to adjust the population to match target margins.
      2. Args:
         a. population (np.array): Initial population array.
         b. target_margins (pd.Series): Target margins for age distribution.
         c. max_iterations (int): Maximum number of IPF iterations (default is 1000).
         d. tolerance (float): Tolerance for stopping criterion (default is 1e-5).
      3. Returns:
         a. Adjusted population array after IPF.
   v. generate_random_age:
      1. Generates a random age within a specified age group range.
      2. Args:
         a. age_group (str): Age group label.
      3. Returns:
         a. An integer representing a random age within the specified age group range.

An example Main Config pseudo-script and schema is further provided, which provides the functionality of synthetic data generation module 200. Again, in the present example, the geographic region is a city and the timepoint is a specific year.
a. Imports:
   i. Essential Libraries: import of the necessary Python libraries for data manipulation, fuzzy matching, and API interactions. These include pandas, numpy, sys, csv, fuzzywuzzy, and custom modules for each stage of the pipeline.
   ii. Pipeline Scripts: It imports modules representing individual pipeline stages:
      1. eurostat_data_processing_one: Downloads and processes demographic data from Eurostat.
      2. open_streetmap_two: Acquires geographic data (buildings, boundaries) from OpenStreetMap.
      3. european_synthetic_pop_three: Generates a synthetic population based on demographic data.
      4. household_to_building_four: Assigns households to buildings and merges data.
      5. create_european_household_data: Processes and combines synthetic population data.
      6. ethnicity_breakdown_six: Distributes ethnicities based on country-specific data .
b. Global Variables:
   i. CITY: Stores the city name provided as a command-line argument. This is the primary target city for the pipeline.
   ii. INDICE_INTEREST: Specifies the Eurostat indicator of interest (e.g., population density).
c. Functions:
   i. find_best_match(user_input, df, column_name):
      1. Takes a city name provided by the user and a DataFrame containing Eurostat labels.
      2. Uses fuzzy matching to find the best matching Eurostat label for the city.
      3. Returns the corresponding row from the DataFrame.
   ii. distribute_ethnicities(population_df, ethnicity_distribution):
      1. Takes a DataFrame of synthetic population data and a list of ethnicity percentages.
      2. Randomly assigns ethnicities to individuals in the population, maintaining the specified distribution.
d. Main Execution (if __name__ == "__main__":)
   i. Eurostat Data Processing (Pipeline 1; demographic dataset module 201):
      1. Reads the Eurostat label mapping CSV.
      2. Finds the best matching Eurostat label for the input city.
      3. Initialises a EurostatDownload object from the eurostat_data_processing_one module.
      4. Executes the first pipeline stage:
         a. Downloads and cleans Eurostat data.
         b. Filters data based on the city's Eurostat label.
         c. Extracts the specified indicator for the city.
         d. Visualises the extracted data.
   ii. OpenStreetMap Data Processing (Pipeline 2; population per demographic module 202):
      1. Initialises an APICallOSM object from the open_streetmap_two module.
      2. Executes the second pipeline stage:
         a. Downloads city boundary data from OpenStreetMap.
         b. Downloads building data (polygons).
         c. Extracts building centroids and saves them as a CSV.
         d. Downloads transportation edges (roads, railways).
         e. Combines building data with the city boundary.
         f. Retrieves population data from Wikidata based on the city name.
         g. Prepares demographic data for synthetic population generation.
   iii. Synthetic Population Generation (Pipeline 3; synthetic population generation module 203):
      1. Initialises a SyntheticPopulationGenerator object from the european_synthetic_pop_three module.
      2. Executes the third pipeline stage:
         a. Loads and prepares demographic data.
         b. Generates a synthetic population for the specified year (e.g., 2023).
   iv. Household and Building Assignment (Pipeline 4; population distribution across households module 205):
      1. Initialises a HouseholdGenerator object from the household_to_building_four module.
      2. Executes the fourth pipeline stage:
         a. Assigns households to buildings based on the synthetic population and building locations.
         b. Merges population and building data into a single DataFrame.
         c. Saves the merged data as a CSV.
         d. Processes and combines synthetic population data usingSyntheticPopulationProcessorfromcreate_european_household_data.
         e. Distributes ethnicities to the synthetic population usingEthncityBreakdownfromethnicity_breakdown_six.
         f. Saves the ethnicity-enriched population data as a CSV.

Example Python pseudo-code for an example ethnicity distribution module 206 is provided. This Python script is responsible for distributing ethnicities across a synthetic population based on country-specific data captured from an LLM. It uses a CSV file containing ethnicity breakdown percentages for each country in the European Union (EU27).
a. Class Definition:
   i. EthncityBreakdownclass: This class encapsulates the logic for handling ethnicity distribution.
b. Constructor (__init__)
   i. Takes two parameters:
      1. dataframe_input: The path to the CSV file containing ethnicity breakdown data.
      2. country_name: The name of the country for which ethnicity distribution is required.
   ii. Reads the CSV file into a Pandas DataFrame (european_ethnicity_dataset).
   iii. Handles potential parsing errors by creating an empty DataFrame if the file cannot be read.
c. Methods
   i. get_dataset_info(): Returns information about the ethnicity breakdown dataset.
   ii. get_specific_country(): Filters the dataset to retrieve data for the specified country.
   iii. get_ethnicity_percentage():
   iv. Extracts the major ethnic groups and their corresponding percentages from the country-specific data.
   v. Returns a list of tuples, where each tuple represents an ethnic group and its percentage.
d. Functionality
   i. The script uses the provided CSV file as a source of truth for ethnicity breakdown in the EU27.
   ii. It filters the dataset based on the provided country name.
   iii. It extracts the major ethnic groups and their percentages for the selected country.
   iv. It returns this information as a list of tuples, which may be used to distribute ethnicities randomly across the synthetic population.
   v. In essence, this script provides a mechanism to ensure that the synthetic population reflects the ethnic diversity of the target country, based on real-world data.

Conventional use of LLM-based techniques is limited in that data is not necessarily validated when input in the training set within the training phase of the LLM. The knowledge therein is often static and may not be accurate in respect of dates more recent than the date of preparation of the training set. With the present disclosure, the techniques herein are able to create micro-level (individual) data for populations to a very accurate level of certainty, based on the ground truth (e.g., census data and geographical structures).

Synthetic population generation module 203 utilises IPF to weight the aggregated data and then to apply weighted sampling such that the resulting synthetic population data reflects the desired proportions. The IPF algorithm therefore adjusts the initial population based on target marginals, and ensures accurate representation of age and gender distribution. Mathematically, IPF is a technique to find a matrix *X*, which is closest to another matrix *Z* subject to the constraint that the row and column marginals of *X* be (nearly) identical to a target matrix *Y*. IPF may also be referred to as biproportional fitting, the RAS algorithm, raking, or matrix scaling.

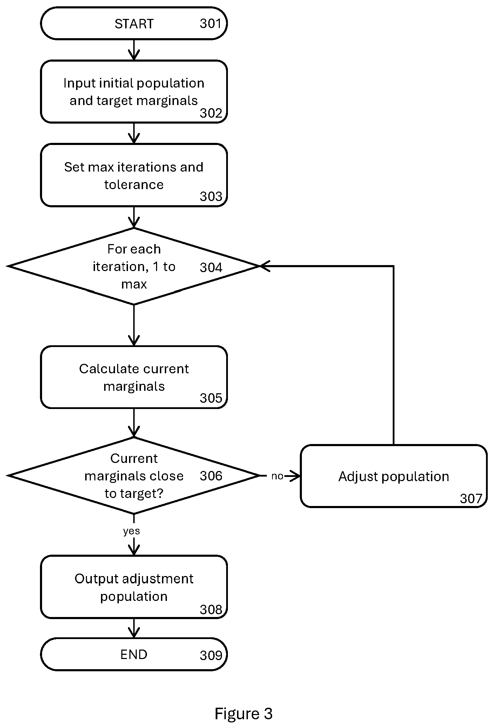

Figure 3 provides a flowchart detailing the use of IPF for population synthesis, as implemented using computing means. For two-dimensional contingency table population data *X* (aggregated demographic data in the present context), the classical IPF algorithm alternates between adjusting the elements to satisfy the target row marginals, u, and then the target column marginals, *v*.

At 301, the computing means initiates the IPF procedure and, at 302, accepts input of an initial dataset and target margins. Initially, ${m}_{ij}^{0} = {x}_{ij}$ such that *M* is set to *X.*

At 303, the computing means sets a maximum number of iterations and the tolerance. If the difference between the current marginals and target marginals is less than the tolerance for all categories, the IPF algorithm stops. Tolerances in this context are based on the aggregated statistics from the datasets (e.g., Eurostat datasets) and are reflective of proportions of the population characteristics from the available datasets.

At 304, the computing means assesses the current iteration number in respect of the preset maximum number of iterations. So long as the termination criterion is not met, the computing means, at 305, proceeds to calculate the current marginals. At 306, the computing means determines if the current marginals are close to the target marginals.

In the event that the current marginals are not close to the target marginals (306, "no"), the computing means adjusts the population at 307. The computing means adjusts the population to satisfy the target row marginals, which essentially involves weighted normalization: ${m}_{ij}^{1} = \frac{{m}_{ij}^{0} {u}_{i}}{{\sum }_{J} {m}_{ij}^{0}}$ Similarly, the computing means adjusts to satisfy the target column marginal: ${m}_{ij}^{2} = \frac{{m}_{ij}^{1} {v}_{i}}{{\sum }_{I} {m}_{ij}^{1}}$ The computing means then sets ${m}_{ij}^{0}$ to ${m}_{ij}^{2}$. The adjustment procedure is repeated until the current marginals are close to the target marginals (306, "yes") and, at 308, the computing means outputs the adjusted population, M. The computing means terminates the IPF procedure at 309.

Consider, for example, initial aggregated data set such as that in Table 1 below:

| | Column1 | Column2 | SUM |
|---|---|---|---|
| Row1 | 24 | 30 | 54 |
| Row2 | 12 | 6 | 18 |
| SUM | 36 | 36 | |

Row1 and Row2 may be, for example, genders male and female, respectively. Column1 and Column2 may be, for example, ages above and below 50, respectively (i.e., there are 24 male individuals above 50 years old, 26 female individuals under 50 years old, etc.). The target sums for Row1 and Row2 are [70,34] in the present example, and the target sums for Column1 and Column2 are [43, 43]. For each row, *i,* and column, *j*, the data is updated using the IPF algorithm described above. Following a first iteration, the data is updated to that in Table 2 below:

| | Column1 | Column2 | SUM |
|---|---|---|---|
| Row1 | (24×70)/54 = 32.40 | (30×70)/54 = 38.88 | 71.28 |
| Row2 | (12×34)/18 = 22.66 | (6×34)/18 = 11.33 | 33.99 |
| SUM | 55.06 | 50.21 | |

This iterative update is performed until convergence occurs. The final adjusted population, M, may then be normalized to provide weights that correspond to *i* and *j* values. One may then divide the final adjusted population M by the number of samples and re-assign these observation weights to the synthetic data. Alternative approaches to the above classical IPF algorithm may be used, including factor estimation.

The above synthetic data generation module 200 and functionality thereof prepares synthetic population data for a user-entered geographic region, collating data from distinct data sources. In some arrangements, alternative data generation or data retrieval techniques may be employed on preprepared data sources. For instance, the former synthetic data generation module 200 may be used where individual-level data is not readily available and a synthetic data retrieval module 400 may be used where individual-level data is preprepared.

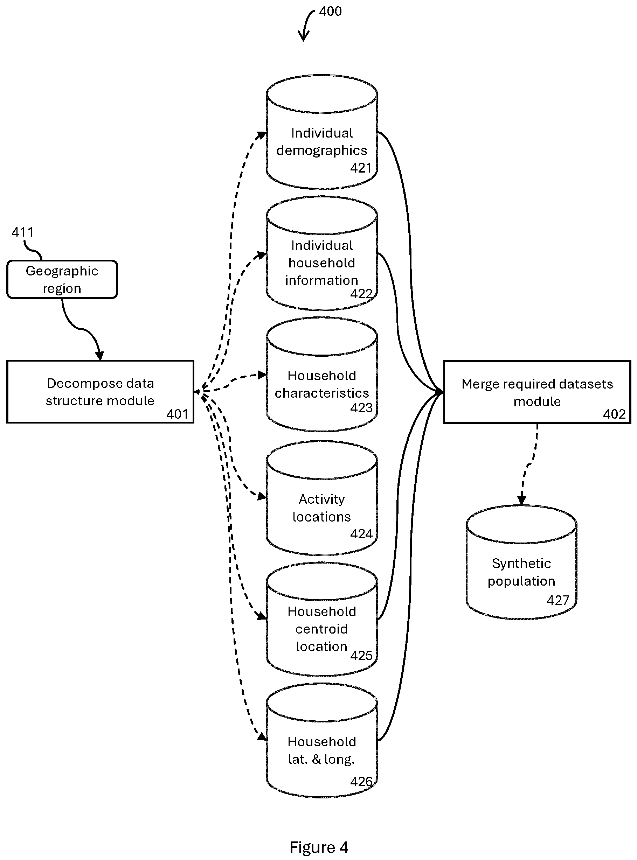

Figure 4 is a schematic overview of example modules and datastores as used in a synthetic data retrieval method. The modules here may be collectively referred to a synthetic data retrieval module 400.

The module 400 focuses on processing and manipulating existing population data. In examples, the existing population data is stored in Protocol Buffers (Protobuf) format, which contains structured population data. Protobuf data structures may be populated manually by the use or may be sourced, for example, from The Alan Turing Institute's Synthetic Population Catalyst project. These data structures source data from various sources, including UK census data, NHSx, and the Department for Work and Pensions. In the present example, the Protobuf file includes various instances of aggregated data.

The module 400 processing comprises the following steps. Initially, the user provides the name of the geographic region 411 through a graphical interface. Decompose data structure module 401 takes a Protobuf data structure corresponding to the geographic region 411 and decomposes the data structure into datasets 421 to 426. These datasets include a dataset with individual person demographics (individual demographics 421), a dataset with individual households and locations (individual household information 422), a dataset with household characteristics, including type, location, rooms, number of cars, etc. (household characteristics 423), a dataset with the locations of activities as performed by individuals (activity locations 424), a dataset with the centroid latitude and longitude of the polygon describing the households (household centroid location 425), and a dataset with the specific latitude and longitude of the household (household lat. & long. 426). Decompose module 401 takes the aggregated demographic data available in the Protobuf file and break this data down. Through incorporation of OpenStreetMap household information, the synthetic population may be distributed into households, and these households are then distributed into buildings within the geographic region. For example, the population may be distributed randomly into households within the area in which the synthetic population resides, and these households may then be distributed or allocated to buildings within the same geographic region, using OpenStreetMap information.

Merge required datasets module 402 merges the relevant datasets from amongst the constituent datasets, which are relevant for the subsequent task at hand (which, of course, is subject to variation).

In the present example, the synthetic data retrieval module 400 is implemented using Python. The following two example classes are provided, which are used for the decomposition of Protobuf data structures into CSV datasets and the merger of CSV datasets into synthetic population data.

### MergeDatasets Class:

a. Purpose: This class merges two datasets based on a common identifier, fills missing geospatial information, and assigns specific attributes.
b. Attributes:
   i. dataset_1: DataFrame representing the first dataset.
   ii. dataset_2: DataFrame representing the second dataset.
c. Methods:
   i. __init__(self, dataset_one_location: str, dataset_two_location: str) → None: Initialises the class by loading datasets from specified locations.
   ii. combine_dataframe(self) → None: Merges the two datasets on a common identifier and saves the result to a CSV file.
   iii. house_latitude_longitude_assigned(self) → None: Assigns latitude and longitude to households based on their MSOA (Middle Super Output Area) codes in a round-robin manner and saves the result.
   iv. mapping_msoa(self, latitudes, longitudes) → list: Maps latitude and longitude to MSOA codes using an external API.
   v. fill_empty_msoas(self) → None: Fills missing MSOA codes based on the most common MSOA in surrounding rows.
   vi. person_to_household(self) → None: Merges individual-level and household-level datasets by exploding member data and matching household identifiers.

### ExtractCSV Class:

a. Purpose: This class extracts data from protobuf files and exports it to CSV format.
b. Attributes:
   i. file_path (str): Path to the protobuf file.
   ii. population_string: A string representation of the population data.
   iii. pop: Parsed population data from the protobuf file.
c. Methods:
   i. data_load(self) → None: Parses the protobuf file and loads the population data.
   ii. person_csv(self) → None: Extracts per-person attributes and exports them to a CSV file.
   iii. household_csv(self) → None: Extracts household-level data and exports it to a CSVfile.
   iv. household_details_csv(self) → None: Extracts detailed household information and exports it to a CSV file.
   v. location_points(self) → None: Extracts geospatial data for various activity venues and exports it to a CSV file.
   vi. home_locations_msoa(self) → None: Extracts and exports home locations at the MSOA level.
   vii. home_locations_specific(self) → None: Extracts and exports specific home locations based on geospatial coordinates.

The following pseudocode demonstrates suitable example processing of the synthetic data retrieval module 400.

```
 BEGIN
 # Step 1: Convert .pb files to CSV
 FUNCTION ConvertPBtoCSV(input_pb_file):
  LOAD protobuf file
  EXTRACT population data
  FOR each person in population:
     STORE personal attributes (age, gender, ethnicity, health conditions, etc.)
     STORE household ID and MSOA code
  SAVE personal data to "people.csv"
  FOR each household in population:
     STORE household attributes (household ID, members, MSOA, OA codes)
  SAVE household data to "household.csv"
  FOR each household in population:
     IDENTIFY home location using MSOA building centroid
  SAVE home locations to "home_locations_MSOA.csv"
  FOR each venue in population:
     IF venue is a home:
        STORE latitude, longitude, and type
  SAVE specific home locations to "home_locations_specific.csv"
  END FUNCTION
  # Step 2: Merge and Process Datasets
  FUNCTION MergeDatasets(file_1, file_2):
  LOAD dataset_1 from file_1
  LOAD dataset_2 from file_2
  MERGE datasets on common identifier
  REMOVE duplicate or unnecessary columns
  SAVE merged data to "home_locations_with_MSOA.csv"
  END FUNCTION
  FUNCTION AssignHouseholdLocations():
  LOAD "home_locations_with_MSOA.csv"
  LOAD "home_locations_specific.csv"
  FOR each household:
     ASSIGN latitude and longitude from specific locations based on MSOA match
  SAVE updated dataset as "combined_data.csv"
  END FUNCTION
  FUNCTION FillMissingMSOACodes():
  LOAD "home_locations_specific.csv"
  FOR each row:
     IF MSOA code is missing:
      REPLACE with most common MSOA from nearby records
  SAVE updated dataset as "home_locations_specific_w_msoa.csv"
  END FUNCTION
  FUNCTION MapCoordinatesToMSOA(latitudes, longitudes):
  LOAD MSOA boundary shapefile
  CONVERT latitude and longitude to spatial points
  PERFORM spatial join to find MSOA code for each point
  RETURN MSOA codes
  END FUNCTION
  FUNCTION ConvertPersonToHousehold():
  LOAD "people.csv"
  LOAD "combined_data.csv"
  CONVERT household members list to individual rows
  MATCH individuals to household dataset
  SAVE final processed dataset as "final.csv"
  END FUNCTION
  # Execution Pipeline
  CALL ConvertPBtoCSV(input_pb_file)
  CALL MergeDatasets("home_locations_MSOA.csv", "household.csv")
  CALL MergeDatasets("home_locations_with_MSOA.csv", "home_locations_specific.csv")
  CALL FillMissingMSOACodes()
  CALL Assign Household Locations()
  CALL ConvertPersonToHousehold()
  END
```

The above description provides a comprehensive understanding of the technical components and functionalities of an example synthetic data generation module 200 and an example synthetic data retrieval module 400, highlighting the specific steps involved in generating, retrieving, and processing synthetic population data for different regions.

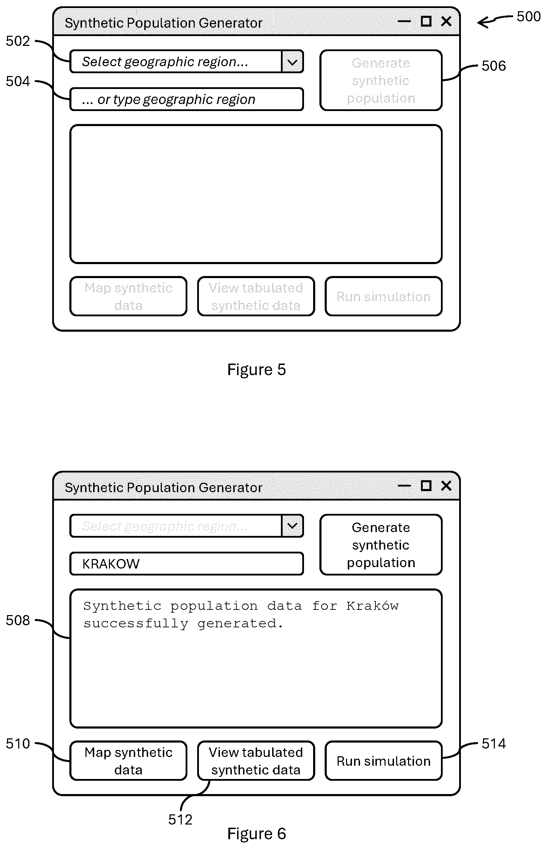

Figure 5 is an example GUI panel 500, suitable for initiating an example synthetic data generation module 200 and/or an example synthetic data retrieval module 400. Element 502 allows for input of a selection of a geographic region using a drop-down menu; any entry in the drop-down menu may correspond to geographic regions for which a corresponding Protobuf data structure exists. Alternatively, element 504 allows for typed input of a geographic region; element 502 may be suitable for input of geographic regions for which a corresponding Protobuf data structure does not exist. When either element 502 or element 504 is populated, selection of button 506, labelled "generate synthetic population", initiates synthetic data generation processing or synthetic data retrieval processing, respectively (e.g., using synthetic data generation module 200 or example synthetic data retrieval module 400). Selection of button 506 may not be enabled until a valid input is provided within either element 502 or element 504.

The following provides a description of how an example GUI may integrate and reflect the processing provided by example processing modules.
a. Data Input and Configuration
   i. Functionality: The GUI may allow users to specify certain configurations or settings that will be used across the different data processing scripts. This may include setting file paths, choosing datasets, or defining parameters for data processing.
   ii. UI Elements: A configuration panel or menu where users may input or select various options. This may be a series of text boxes, dropdown menus, or checkboxes that allow the user to define specific settings (e.g., selecting a data source or specifying a directory for saving output).
b. Household Data Generation
   i. Functionality: The GUI provides a way for users to initiate the generation or compilation of European household data. This may involve selecting specific parameters or models to be used in the data generation process.
   ii. UI Elements: A "Generate Household Data" button may, when clicked, run the above-described create_european_household_data.py script. There may also be options for the user to specify certain parameters (e.g., the geographic region or demographic characteristics) through input fields or dropdowns before running the process.
c. Synthetic Population Creation
   i. Functionality: Users may use the GUI to create or simulate a synthetic population dataset based on predefined or user-specified criteria. This may be particularly advantageous for demographic analysis or policy simulations.
   ii. UI Elements: Similar to the household data generation, there may be a dedicated section in the GUI for synthetic population creation. Users may input parameters such as population size, age distribution, or geographic scope. A button such as "Create Synthetic Population" may trigger the relevant script.
d. Data Processing and Analysis
   i. Functionality: The GUI may include features that allow users to process raw Eurostat data, clean the data, or prepare the data for analysis. This may be particularly useful for researchers or analysts working with large datasets.
   ii. UI Elements: There may be a "Process Data" button that users click after selecting the raw Eurostat data files. Additional GUI components may include progress indicators or logs that show the processing status, allowing users to monitor the workflow.
e. Output Display and Interaction:
   i. Functionality: After the scripts have been run (e.g., generating household data or processing Eurostat data), the GUI may display the results directly or provide options to save the processed data to a file.
   ii. UI Elements: The GUI might have a text display area or a grid that shows the results or summaries of the operations performed by the scripts. Users may also be presented with options to download or export the processed data for further use.
f. Integration and Workflow:
   i. Functionality: The GUI may integrate these various scripts into a cohesive workflow, allowing users to move from configuring settings to processing data and finally viewing or exporting results without needing to interact directly with the underlying code.
   ii. UI Elements: The layout may be organised into tabs or sections, each dedicated to a different aspect of the data processing workflow, ensuring that users may easily navigate through the different stages of their task.

Figure 6 is the same example GUI panel 500, following successful synthetic population data generation. In this instance, the user has input the Polish city "Krakow" into element 503 and initiated synthetic data generation using button 506. Text panel 508 provides a status update, letting the user know that the synthetic population data has successfully been generated. GUI panel 500 further includes: button 510, which allows the user to map the generated synthetic population data; button 512, which allows the user to view the synthetic population data in tabulated form; and button 514, which allows the user to initiate a simulation using the synthetic population data Selection of buttons 510, 512, or 514 may not be enabled until synthetic population data is generated or retrieved.

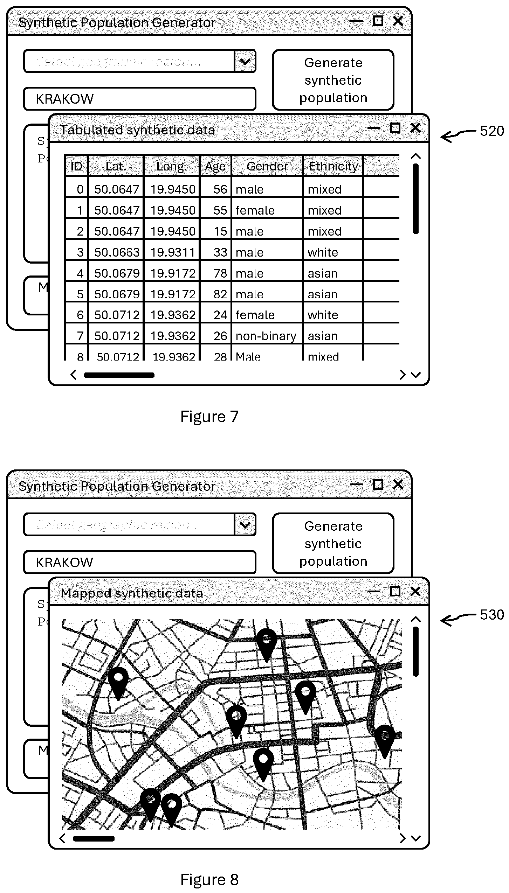

Figure 7 shows another example GUI panel 520,which appears on selection of button 512 of GUI panel 500. GUI panel 520 includes a tabulated representation of the generated synthetic population data. In the present example, the data may include an ID for an individual, latitude and longitude for that individual's household, the age of the individual, the gender of the individual, and the ethnicity of the individual. Of course, additional and/or alternative individual characteristics may be provided. And of course, the tabulated data may alternatively be provided in text panel 508 of GUI panel 500.

Figure 8 shows another example GUI panel 530,which appears on selection of button 510 of GUI panel 500. GUI panel530 includes a map-based representation of the generated synthetic population data. In the present example, the latitude and longitude of each individual within the generated synthetic population data may be used to plot the household location of that individual. Further, on selection of each plotted location, additional information (such as the corresponding age, gender, ethnicity, etc.) may be provided to the user (not shown). And of course, the map-based representation of the data may alternatively be provided in text panel 508 of GUI panel 500.

The present disclosure provides an efficient approach for the generation of synthetic population data for specified cities and regions, utilising a combination of traditional data processing techniques and advanced artificial intelligence capabilities. The system, divided into two modules tailored for geographic regions with and without preexisting data structures., leveraging readily available data sources like Eurostat, OpenStreetMap, and Wikidata, along with structured population data stored in Protobuf files.

The use of IPF ensures accurate representation of demographic statistics while incorporation of LLMs in the assigning particular characteristics to the synthetic population (e.g., ethnicity) significantly enhances the realism and accuracy of the generated synthetic population data. The LLM's ability to analyse and interpret complex demographic patterns, combined with its capacity to learn from vast amounts of data, allows for a more nuanced and representative depiction of, for example, ethnic diversity within the synthetic population.

The system's modular design allows for adaptability and scalability, enabling its application to a wide range of cities and regions. The ability to generate detailed and realistic synthetic population data has significant implications for various fields, including urban planning, transportation modelling, public health research, and social impact analysis.

The techniques herein provide a valuable tool for researchers, policymakers, and other stakeholders seeking to understand and model complex population dynamics. By providing a comprehensive and accurate representation of population characteristics, the system facilitates informed decision-making and contributes to the development of more effective and equitable policies.

The skilled reader will appreciate that many hardware configurations are suitable for implementing techniques according to the present disclosure. One suitable hardware implementation to perform synthetic data generation or synthetic data retrieval in accordance with embodiments has the following specifications: Intel Core i7-5930K, NVIDIA GeForce RTX 3090 (24 GiB), 64 GB host memory, and running Ubuntu 20.04.6 LTS.

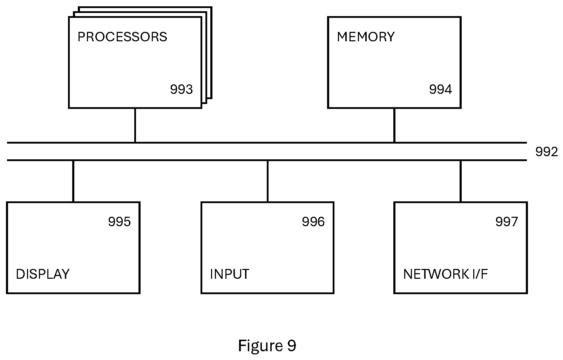

Figure 9 is a block diagram of a computing device, such as a data processing server, which embodies the present invention, and which may be used to implement a me method for synthetic data generation. The computing device comprises a plurality of processors or processing units 993 and memory, 994. Optionally, the computing device also includes a network interface 997 for communication with other computing devices, for example with other data storage devices or external data processing devices. An embodiment may be composed of a network of such computing devices.

Optionally, the computing device also includes one or more input mechanisms such as keyboard and mouse 996, and a display unit such as one or more monitors or screens 995. The components are connectable to one another via a bus 992.

The memory 994 may include a computer readable medium, a term which may refer to a single medium or multiple media (e.g., a centralised or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The plurality of processors 993 is configured to control the computing device and execute processing operations, for example executing code stored in the memory to implement the method for synthetic data generation described here and in the claims. The memory 994 stores data being read and written by the plurality of plurality of processors 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an ASIC, a FPGA, a digital signal processor (DSP), network processor, or the like. In one or more embodiments, a processor is configured to execute instructions for performing the operations and steps discussed herein.

Display 995 may display a user interface. Input 996, in the form of a touchscreen or screen and keyboard and/or voice, may be used for user input. The user interface - including, for example, GUI Panel 500 - may be embodied as a user application shown on the display and optionally connected to the audio input/output of the user device for voice input and audio output. Local storage, for example of geographic region details, may be provided by memory 994, and plurality of processors 993 may carry out background functions. The core functionality (generation of synthetic population data, for example) may preferably be implemented remotely from the user device, for example on the cloud.

The network interface (network I/F) 997 may be connected to a network, such as the internet, and is connectable to other such computing devices via the network. The network I/F 997 may control data input/output from/to other apparatus via the network. Other peripheral devices such as microphone, speakers, etc. may be included in the computing device.

Plurality of processors 993 may execute instructions stored on a portion of the memory 994 to exchange data between modules via bus 992 via network I/F 997 to external entities, such as data stores and simulation hardware.

Methods embodying the present invention may be carried out on a computing device such as that illustrated in Figure 9. Such a computing device need not have every component illustrated in Figure 9, and may be composed of a subset of those components. Methods embodying the present invention may be carried out by a single computing device in communication with one or more data storage servers via a network. The computing device may be a data storage itself storing prepopulated data structures, lists of geographic regions, and statistical parameters (e.g., for use in IPF), etc.

A method embodying the present invention may be carried out by a plurality of computing devices operating in cooperation with one another. One or more of the plurality of computing devices may be a data storage server storing at least a portion of prepopulated data structures, lists of geographic regions, and statistical parameters (e.g., for use in IPF), etc.

In addition, the modules and components may be implemented as firmware or functional circuitry within hardware devices. Further, the modules and components may be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilising terms such as "receiving", "accepting", "acquiring", "generating", "assigning", "providing", "outputting", or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of methods and apparatus described herein may be made.

The following numbered statements are useful for understanding the present invention.
S1. A computer-implemented method for synthetic data generation, the method comprising: accepting input of a target geographic region; acquiring aggregated demographic data for the target geographic region; generating a synthetic population based on the aggregated demographic data using iterative proportional fitting, IPF; acquiring infrastructure information for the target geographic region; assigning the synthetic population to a plurality of households using the infrastructure information, thereby forming synthetic population data; outputting the synthetic population data.
S2. The method for synthetic data generation of S1, further comprising assigning ethnicity data to the synthetic population using ethnicity demographic data for the target geographic region.
S3. The method for synthetic data generation of S2, wherein the ethnicity demographic data is acquired using a large language model, LLM .
S4. The method for synthetic data generation of any preceding statement, further comprising accepting input of a target timepoint; and acquiring the aggregated demographic data for the target geographic region and the target timepoint; and/or acquiring the infrastructure information for the target geographic region and the target timepoint.
S5. The method for synthetic data generation of any preceding statement, wherein the synthetic population data comprises any or all of age, gender, health, income, ethnicity, and household information.
S6. The method for synthetic population data generation of any preceding statement, further comprising providing a graphical user interface, GUI; accepting the input of the target geographic region using the GUI; and outputting a representation of the synthetic population data using the GUI.
S7. The method for synthetic data generation of any preceding statement, further comprising outputting the synthetic population data for use in any or all of: a traffic simulation for the geographic region, the traffic simulation further using traffic data for the geographic region; a resource allocation simulation for the geographic region, the resource allocation simulation using real resource data for the geographic region; and an epidemiology simulation for the geographic region, the epidemiology simulation using real epidemiologic data for the geographic region.
S8. A computer-implemented method for obtaining population data for a geographic region, the method comprising: accepting input of a target geographic region; when the target geographic region corresponds to a first predetermined plurality of geographic regions, generating synthetic population data for the target geographic region using the method of any of statements S1 to S7; and when the target geographic region corresponds to a second predetermined plurality of geographic regions, retrieving population data for the target geographic region.
S9. A data processing apparatus comprising means for accepting input of a target geographic region; a processing unit configured to execute the method of any of statements S1 to S8.
S10. A computer program comprising instructions that, when the program is executed by a data processing apparatus, cause the data processing apparatus to carry out the method of any of statements S1 to S8.
S11. A computer-readable medium comprising instructions that, when executed by a data processing apparatus, cause the data processing apparatus to carry out the method of any of statements S1 to S8.

## Claims

1. A computer-implemented method for synthetic data generation, the method comprising:
accepting input of a target geographic region;
acquiring aggregated demographic data for the target geographic region;
generating a synthetic population based on the aggregated demographic data using iterative proportional fitting, IPF;
acquiring infrastructure information for the target geographic region;
assigning the synthetic population to a plurality of households using the infrastructure information, thereby forming synthetic population data; and
outputting the synthetic population data.

2. The method for synthetic data generation of claim 1, further comprising assigning ethnicity data to the synthetic population using ethnicity demographic data for the target geographic region.

3. The method for synthetic data generation of claim 2, wherein the ethnicity demographic data is acquired using a large language model, LLM.

4. The method for synthetic data generation of any preceding claim, further comprising:
accepting input of a target timepoint;
acquiring the aggregated demographic data for the target geographic region and the target timepoint; and/or
acquiring the infrastructure information for the target geographic region and the target timepoint.

5. The method for synthetic data generation of any preceding claim, wherein the synthetic population data comprises any or all of age, gender, health, income, ethnicity, and household information.

6. The method for synthetic population data generation of any preceding claim, further comprising:
providing a graphical user interface, GUI;
accepting the input of the target geographic region using the GUI; and
outputting a representation of the synthetic population data using the GUI.

7. The method for synthetic data generation of any preceding claim, further comprising outputting the synthetic population data for use in any or all of:
a traffic simulation for the geographic region, the traffic simulation further using traffic data for the geographic region;
a resource allocation simulation for the geographic region, the resource allocation simulation using real resource data for the geographic region; and
an epidemiology simulation for the geographic region, the epidemiology simulation using real epidemiologic data for the geographic region.

8. A computer-implemented method for obtaining population data for a geographic region, the method comprising:
accepting input of a target geographic region;
when the target geographic region corresponds to a first predetermined plurality of geographic regions, generating synthetic population data for the target geographic region using the method of any of claims 1 to 7; and
when the target geographic region corresponds to a second predetermined plurality of geographic regions, retrieving population data for the target geographic region.

9. A data processing apparatus comprising:
means for accepting input of a target geographic region;
a processing unit configured to execute the method of any of claims 1 to 8.

10. A computer program comprising instructions that, when the program is executed by a data processing apparatus, cause the data processing apparatus to carry out the method of any of claims 1 to 8.

11. A computer-readable medium comprising instructions that, when executed by a data processing apparatus, cause the data processing apparatus to carry out the method of any of claims 1 to 8.

## Amended claims

### Amended claims in accordance with Rule 137(2) EPC.

1. A computer-implemented method for synthetic data generation, the method comprising:
accepting input of a target geographic region;
acquiring aggregated demographic data for the target geographic region;
generating a synthetic population based on the aggregated demographic data using iterative proportional fitting, IPF;
acquiring infrastructure information for the target geographic region;
assigning the synthetic population to a plurality of households using the infrastructure information to link the synthetic population to household structures within the target geographic region, thereby forming synthetic population data; and
outputting the synthetic population data.

2. The method for synthetic data generation of claim 1, further comprising assigning ethnicity data to the synthetic population using ethnicity demographic data for the target geographic region.

3. The method for synthetic data generation of claim 2, wherein the ethnicity demographic data is acquired using a large language model, LLM.

4. The method for synthetic data generation of any preceding claim, further comprising:
accepting input of a target timepoint;
acquiring the aggregated demographic data for the target geographic region and the target timepoint; and/or
acquiring the infrastructure information for the target geographic region and the target timepoint.

5. The method for synthetic data generation of any preceding claim, wherein the synthetic population data comprises any or all of age, gender, health, income, ethnicity, and household information.

6. The method for synthetic population data generation of any preceding claim, further comprising:
providing a graphical user interface, GUI;
accepting the input of the target geographic region using the GUI; and
outputting a representation of the synthetic population data using the GUI.

7. The method for synthetic data generation of any preceding claim, further comprising outputting the synthetic population data for use in any or all of:
a traffic simulation for the geographic region, the traffic simulation further using traffic data for the geographic region;
a resource allocation simulation for the geographic region, the resource allocation simulation using real resource data for the geographic region; and
an epidemiology simulation for the geographic region, the epidemiology simulation using real epidemiologic data for the geographic region.

8. A computer-implemented method for obtaining population data for a geographic region, the method comprising:
accepting input of a target geographic region;
when the target geographic region corresponds to a first predetermined plurality of geographic regions, generating synthetic population data for the target geographic region using the method of any of claims 1 to 7; and
when the target geographic region corresponds to a second predetermined plurality of geographic regions, retrieving population data for the target geographic region.

9. A data processing apparatus comprising:
means for accepting input of a target geographic region;
a processing unit configured to execute the method of any of claims 1 to 8.

10. A computer program comprising instructions that, when the program is executed by a data processing apparatus, cause the data processing apparatus to carry out the method of any of claims 1 to 8.

11. A computer-readable medium comprising instructions that, when executed by a data processing apparatus, cause the data processing apparatus to carry out the method of any of claims 1 to 8.
